# FASCICULE DE BREVET EUROPEEN

(11) **EP 1 699 067 B1**
(45) Date de publication et mention de la délivrance du brevet: **27.08.2008**
(21) Numéro de dépôt: 06100810.8
(22) Date de dépôt: 26.03.2002
(51) Int. Cl.: H01J 27/22, H01J 27/02, H01J 37/305, H01J 37/30

(54) **Procédé de réglage d'un faisceau d'ions**
Verfahren zur Regelung eines Ionenstrahls
Method of controlling an ion beam

(30) Priorité: 28.03.2001 FR 0104173
(43) Date de publication de la demande: 06.09.2006
(62) Demande divisionnaire de: 02722381.7
(73) Titulaire: CENTRE NATIONAL DE LA RECHERCHE SCIENTIFIQUE (CNRS), 75016 Paris (FR)
(72) Inventeur: Gierak, Jacques, 91220 Le Plessis Pate (FR); Lagadec, Yvon, 92160 Antony (FR); Septier, Albert, 92340 Bourg la Reine (FR)
(74) Mandataire: Jacquard, Philippe Jean-Luc

(56) Documents cités:
- WO-A-97/40493
- JP-A- 63 305 358
- US-A- 4 503 329
- "Focused ion beam nanolithography on AlF3 at a 10 nm scale" APPLIED PHYSICS LETTERS, AIP, AMERICAN INSTITUTE OF PHYSICS, MELVILLE, NY, US, vol. 70, no. 15, 14 avril 1997 (1997-04-14), pages 2049-2051, XP012017635 ISSN: 0003-6951

## Description

### Domaine technique

La présente invention concerne un dispositif de génération d'un faisceau d'ions ainsi qu'un procédé de réglage de ce faisceau.

Cette invention s'applique notamment à la fabrication de structures de très petites tailles, inférieures à 50 nm, et plus particulièrement à la fabrication de nano-structures ayant des tailles de l'ordre de 10 nm ou moins.

L'invention trouve des applications dans divers domaines tels que l'électronique (en particulier en ce qui concerne les dispositifs - par exemple les transistors - à électron unique), le stockage de données à ultra-haute densité (utilisant des nano-structures formées sur des matériaux magnétiques) et les dispositifs à semi-conducteurs à ultra-haute vitesse (utilisant des nano-structures formées sur des matériaux semi-conducteurs).

Indiquons dès maintenant que la présente invention utilise de préférence une source ponctuelle d'ions, c'est-à-dire une source d'ions à zone émissive ponctuelle et très brillante.

De plus, cette source ponctuelle d'ions est de préférence une LMIS, c'est-à-dire une source d'ions à métal liquide (en anglais "liquid metal ion source").

### Etat de la technique antérieure

Une source d'ions à métal liquide est connue par le document suivant auquel on se reportera :
[1] Demande internationale PCT/FR 95/00903, numéro de publication internationale WO 96/02065, invention de Jacques Gierak et Gérard Ben Assayag, correspondant au brevet américain US-A-5,936,251.
   La source décrite dans ce document [1] est un exemple de source utilisable dans la présent invention.
   Un dispositif de génération d'un faisceau d'ions, comprenant une source d'ions à métal liquide ainsi qu'un système de lentille électrostatique asymétrique à trois éléments, est connu par le document suivant :
[2] US-A-4,426,582, invention de J.H. Orloff et L.W. Swanson.
   Le dispositif connu par le document [2] présente un inconvénient : il ne permet pas de séparer la fonction d'extraction des ions de la fonction d'accélération des ions.
   On connaît en outre des dispositifs de génération de faisceaux d'ions dans lesquels on aligne une source d'ions, un diaphragme et des lentilles électrostatiques de focalisation grâce à des déplacements appropriés de la source d'ions et du diaphragme.
   Ces dispositifs connus, appelés FIB et produisant des faisceaux d'ions focalisés (en anglais "focused ion beams"), ne permettent pas la fabrication de nano-structures de bonne qualité, de tailles inférieures à 50 nm.
   De plus, un dispositif de réglage de la forme d'un faisceau d'ions focalisé est connu par le document suivant :
[3] US-A-4,704,526, invention de H. Kyogoku et T. Kaito (Seiko Instruments and Electronics Ltd.).
   La technique de réglage connue par ce document [3] n'est qu'une transposition de la technique de réglage classiquement utilisée en Microscopie Electronique à Balayage ou en lithographie par faisceaux d'électrons.

Une telle technique n'est pas utilisable dans le domaine nanométrique.

De plus, cette technique connue nécessite la réalisation préalable de coûteux et fragiles marqueurs d'étalonnage qui ne sont pas réutilisables.

### Exposé de l'invention

La présente invention a pour but de remédier aux inconvénients précédents.

Contrairement au dispositif connu par le document [2], le dispositif objet de l'invention permet de séparer la fonction d'extraction des ions de la fonction d'accélération des ions.

De plus, l'invention utilise une technique d'alignement d'un diaphragme et de lentilles électrostatiques selon un axe optique mécaniquement parfait, technique qui conduit à des performances bien supérieures à celles qu'autorisent les dispositifs FIB connus, mentionnés plus haut : la présente invention permet la fabrication de nano-structures de bonne qualité, de tailles inférieures à 50 nm.

En outre, le procédé de réglage de faisceau d'ions objet de l'invention est beaucoup plus précis que la technique connue par le document [3] et ne nécessite pas la réalisation préalable de coûteux et fragiles marqueurs d'étalonnage.

Le procédé objet de l'invention est avantageusement utilisable dans tout système de nano-fabrication par FIB et s'applique en particulier au réglage du faisceau d'ions engendré par le dispositif objet de l'invention.

De façon précise, la présente invention a pour objet un dispositif de génération d'un faisceau d'ions, ce dispositif étant caractérisé en ce qu'il comprend une source d'ions, un moyen d'extraction des ions émis par la source, un moyen d'accélération des ions ainsi extraits, un moyen de sélection des ions ainsi accélérés et un système d'optique électrostatique destiné à focaliser les ions ainsi sélectionnés selon un premier axe, et en ce que le dispositif comprend en outre un moyen de variation de la distance entre la source d'ions et le moyen d'extraction des ions, cette distance étant comptée suivant un deuxième axe qui est parallèle au premier axe et constitue l'axe du faisceau d'ions émis par la source.

Selon un mode de réalisation préféré du dispositif objet de l'invention, la source d'ions est une source ponctuelle d'ions.

De préférence, cette source ponctuelle d'ions est une source d'ions à métal liquide.

Selon un mode de réalisation préféré de l'invention, le moyen d'extraction des ions et le moyen d'accélération des ions sont indépendants l'un de l'autre et contrôlés séparément l'un de l'autre par application de potentiels respectifs variables.

De préférence, le moyen de sélection des ions comprend un moyen de sélection d'un diaphragme parmi une pluralité de diaphragmes et de mise en place du diaphragme sélectionné sur le premier axe.

Le dispositif objet de l'invention comprend en outre, de préférence, un moyen de déplacement de la source parallèlement au moyen de sélection des ions, ce moyen de déplacement étant prévu pour faire coïncider les premier et deuxième axes.

La présente invention a également pour objet un procédé de réglage d'un faisceau d'ions qui est émis par un dispositif de génération de faisceau d'ions vers une cible et qui est apte à éroder cette cible, ce procédé étant caractérisé en ce qu'il comprend une étape de gravure d'un motif de test sur la cible, selon un motif de référence prédéterminé numérisé, une étape de formation d'une image numérisée du motif de test gravé et une étape de différenciation entre cette image numérisée du motif de test gravé et l'image numérisée du motif de référence prédéterminé, et en ce qu'on répète ces étapes après modification d'au moins un paramètre de réglage du dispositif, jusqu'à l'obtention d'un réglage convenable.

Selon un premier mode de mise en oeuvre particulier du procédé objet de l'invention, on forme l'image du motif de test, au moyen du dispositif, en faisant alors fonctionner ce dernier en mode de microscope ionique à balayage et en collectant les électrons secondaires engendrés en balayant la cible par le faisceau d'ions, et l'on numérise l'image obtenue, et les étapes sont répétées après modification d'au moins un paramètre de réglage du dispositif, jusqu'à ce que l'image numérisée du motif de test coïncide avec l'image numérisée du motif de référence.

Dans ce cas, le ou les paramètres de réglage peuvent être des paramètres de focalisation ou des paramètres de correction d'astigmatisme.

Selon un deuxième mode de mise en oeuvre particulier du procédé objet de l'invention, le motif de test est un ensemble de traits de longueur prédéterminée, formé en maintenant le faisceau d'ions dans une position fixe et en déplaçant la cible, et l'image du motif de test est formée par microscopie ionique à balayage puis numérisée et les paramètres sont des paramètres de gain, en vue de l'étalonnage de la taille du champ d'écriture.

### Brève description des dessins

La présente invention sera mieux comprise à la lecture de la description d'exemples de réalisation donnés ci-après, à titre purement indicatif et nullement limitatif, en faisant référence aux dessins annexés sur lesquels :
- la figure 1 est une vue en coupe schématique d'un mode de réalisation particulier du dispositif objet de l'invention, et
- la figure 2 est une vue en perspective schématique et partielle du dispositif de la figure 1, montrant la barrette formant un support de diaphragmes, utilisée dans le dispositif de la figure 1.

### Exposé détaillé de modes de réalisation particuliers

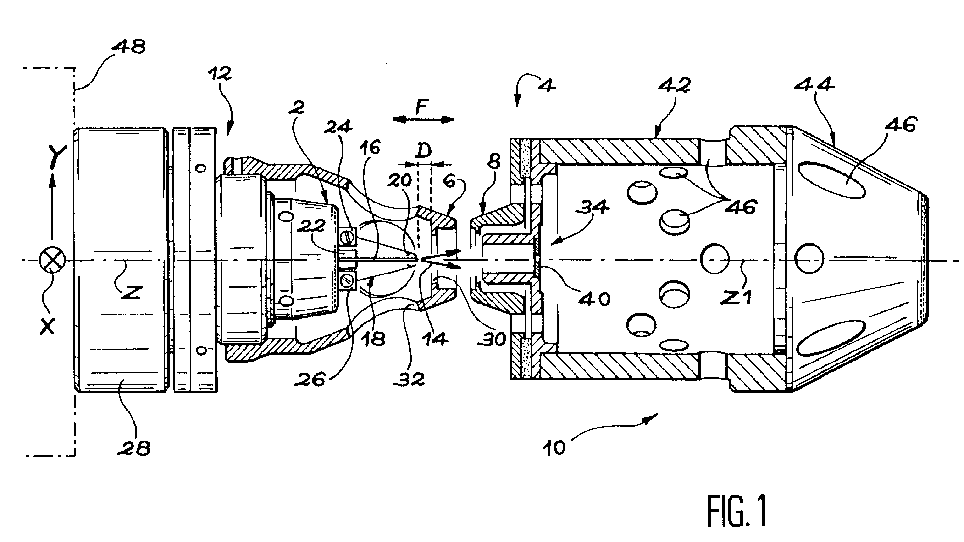

La figure 1 est une vue schématique d'un mode de réalisation particulier du dispositif de génération d'un faisceau d'ions objet de l'invention.

Le dispositif de la figure 1 comprend une source d'ions 2, destinée à produire le faisceau d'ions, ainsi qu'un système 4 d'extraction et d'accélération du faisceau d'ions produit, ce système comprenant une électrode 6 d'extraction du faisceau produit ainsi qu'une électrode 8 d'accélération finale du faisceau extrait. Cette électrode 8 constitue l'entrée du système d'optique électrostatique 10 que comporte également le dispositif de la figure 1.

On voit également sur cette figure le support 12 de 1a source d'ions 2.

Cette source 2 est une source d'ions classique à métal liquide, par exemple destinée à former un faisceau d'ions 14 de gallium.

Cependant, dans la présente invention, on pourrait utiliser une autre LMIS, par exemple du genre de celle qui est décrite dans le document [1], pour former un faisceau d'ions d'aluminium par exemple.

En revenant à la figure 1, la source d'ions classique 2 comprend une tige conductrice 16 terminée par une pointe ainsi qu'un filament conducteur 18 comportant des enroulements 20 que la pointe traverse. De façon connue, la tige est maintenue par une paire de mâchoires 22. On voit aussi des éléments condacteurs 24 et 26 servant à maintenir les extrémités du filament. On voit également une embase 28 sur laquelle est montée le support 12 de la source 2.

L'électrode d'extraction 6 est pourvue d'un diaphragme d'extraction 30 et de trous tels que le trou 32, permettant de pomper les gaz résiduels puisque le dispositif est destiné à fonctionner dans le vide.

Le système d'extraction et d'accélération 4 utilisé dans le dispositif de la figure 1 est original du fait de sa géométrie. L'électrode 6 d'extraction du faisceau 14 n'intercepte ce faisceau 14 en aucun point. Le potentiel d'extraction V0 caractéristique de l'émission des ions est, dans l'exemple considéré, contrôlé en modifiant mécaniquement la distance D entre la source 2 et l'électrode d'extraction 6, cette distance étant comptée parallèlement à l'axe Z du faisceau d'ions 14 émis par la source 2.

Pour ce faire, on utilise un moyen de déplacement de l'électrode d'extraction 6 par rapport à la source 2 (ou de la source par rapport à cette électrode). Ce moyen de déplacement est symbolisé par la flèche F de la figure 1. Il est réalisable par l'homme du métier (et consiste par exemple en un moyen mécanique à base de tige filetée).

En outre, l'électrode d'extraction 6 et l'électrode d'accélération finale 8 sont indépendantes et peuvent être contrôlées séparément par application de potentiels variables.

Le système d'extraction et d'accélération 4 est également original de par ses caractéristiques optiques. En fonctionnement, on applique un potentiel V1 à la source 2 et un potentiel V2 à l'électrode d'extraction 6. Lorsque la différence V1-V2, égale à V0, est de l'ordre de 10 kV, un faisceau d'ions Ga⁺ ayant une densité angulaire de l'ordre de 20 µA par unité d'angle solide (au niveau de l'axe Z du faisceau, formant un axe central de révolution) est émis.

Si l'on augmente V0 jusqu'à environ 17 kV, la densité angulaire mesurée dans les mêmes conditions atteint environ 80 µA/stéradian.

Le système permet ainsi d'augmenter de façon importante la brillance utile d'une LMIS, ce qui constitue l'un des points cruciaux pour l'application de la technique de FIB à la nano-fabrication.

Le système d'extraction et d'accélération 4 est également original du fait de ses caractéristiques d'exploitation qui autorisent une exploitation améliorée du fonctionnement de la source 2.

Chacune des électrodes 6 et 8 peut être pilotée de façon indépendante et spécifique par un générateur de haute tension (par exemple de l'ordre de 20 à 40 kV) adapté (non représenté).

L'émission des ions est contrôlée par une première alimentation de haute tension (non représentée) qui est spécifiquement optimisée pour réguler le courant du faisceau d'ions émis par la source 2. La valeur de ce courant est asservie par contre-réaction à l'aide d'un dispositif analogique optimisé pour avoir une dynamique de réponse rapide. Cet asservissement est obtenu en modifiant la valeur du potentiel appliqué à la source 2 autour d'une valeur permettant d'entretenir une émission des ions par évaporation de champ (de l'ordre de 10⁹ V/m).

On précise que le courant émis peut être connu grâce à un micro-ampèremètre que l'on place dans l'alimentation électrique permettant de polariser la pointe de la source. En variante, pour connaître ce courant, il est possible de mesurer le courant qui frappe l'électrode d'accélération 8.

L'énergie finale des ions est obtenue en portant l'électrode d'accélération finale 8 à un potentiel V2 positif par rapport à la terre. Ce potentiel V2 est contrôlé avec une très haute stabilité. Cette stabilité est assurée par un générateur (non représenté) dont le niveau de stabilité est de l'ordre de 10⁻⁶. On utilise par exemple une alimentation du type à découpage ayant un tel niveau de stabilité.

Le système 4 d'extraction et d'accélération du faisceau d'ions 14 fonctionne avec des performances supérieures à celles des systèmes d'extraction et d'accélération classiques.

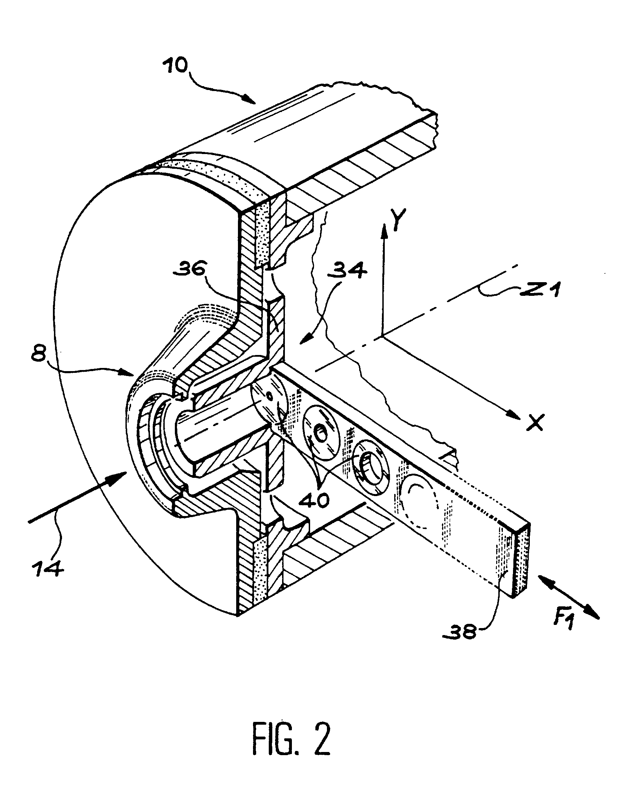

Le dispositif de la figure 1 comprend aussi un système 34 (figure 2) de sélection de l'ouverture optique de la colonne à ions focalisés du dispositif, cette colonne comprenant la source 2, le support de source 12 et le système d'optique électrostatique 10.

Le système de sélection d'ouverture optique 34 comprend un ensemble comportant un fourreau 36 prévu pour recevoir une barrette 38 à commande mécanique ou électro-mécanique symbolisée par la flèche F1, cette barrette 38 portant une pluralité de diaphragmes calibrés 40.

Cette barrette 38 permet de placer sur l'axe central Z1 du système d'optique électro-statique 10, grâce à une translation selon un axe X perpendiculaire à cet axe Z1, un diaphragme calibré 40 choisi parmi les diaphragmes calibrés portés par la barrette 38. Ces diaphragmes définissent différentes valeurs d'ouverture pour le système d'optique électro-statique 10 de la colonne à ions focalisés.

On définit également sur les figures 1 et 2 un axe Y qui est perpendiculaire à l'axe X ainsi qu'à l'axe Z, ce dernier étant parallèle à l'axe Z1.

Le système de sélection d'ouverture optique 34 est original du fait de sa finalité.

A la différence de tous les systèmes de sélection d'ouverture optique connus, ce système utilisé dans le dispositif de la figure 1 n'a pas pour vocation de permettre un alignement entre une source, un diaphragme et des lentilles électro-statiques où les moyens mobiles aptes à être "centrés" selon l'axe X et l'axe Y sont le diaphragme ainsi que la source d'ions. Un tel système connu ne permet en fait que de disposer de plusieurs diaphragmes facilement interchangeables, ayant des tailles différentes ou la même taille.

Dans le cas du dispositif de la figure 1, le centrage des éléments essentiels du système d'optique électro-statique 10, à savoir l'ensemble formé par le diaphragme 40 et par des lentilles électrostatiques 42 et 44 sur lesquelles on reviendra par la suite, est assuré par des tolérances d'usinage serrées. Ainsi, le diaphragme d'entrée du système d'optique électro-statique et les lentilles associées 42 et 44 sont précisément alignés selon un seul et unique axe optique Z1.

Ceci a pour principal intérêt de limiter les aberrations optiques induites par les défauts de décentrement. Ces défauts constituent la limite expérimentale de tous les systèmes d'optique électro-statique connus.

En revenant sur les lentilles électro-statiques 42 et 44 utilisées dans le dispositif de la figure 1, on précise qu'elles sont au nombre de deux, la première 42 étant vue en coupe très schématique dans le plan de la figure 1 tandis que la deuxième 44 est vue de l'extérieur. On voit aussi divers trous 46 dont sont pourvues ces lentilles et qui permettent notamment de faire le vide dans le système d'optique électrostatique 10.

Afin de pouvoir remplacer le diaphragme 40 (figure 1) et positionner le diaphragme de remplacement selon l'axe X avec une incertitude inférieure à un dixième de micromètre, un étalonnage préalable de la position absolue, selon X, du centre de chaque diaphragme est nécessaire. Un contrôle sur un banc du genre des bancs de contrôle optique permet de connaître avec précision la position des différents diaphragmes.

Le seul ajustement réellement nécessaire dans le cas du dispositif de la figure 1 consiste en un déplacement du support 12, portant la source 2, parallèlement au plan de l'entrée du système d'optique électro-statique 10 et donc parallèlement au diaphragme 40 (figure 1), ce plan étant parallèle aux axes X et Y. Cela permet d'aligner l'axe central Z du cône d'émission du faisceau d'ions 14 avec l'axe optique Z1 du système d'optique électro-statique 10.

Pour ce faire, l'embase 28, qui porte le support de source 12, est munie de platines micrométriques symbolisées par les traits mixtes 48 et permettant de déplacer cette embase et donc le support 12 suivant l'axe X et l'axe Y.

Par rapport aux systèmes connus, le système de sélection d'ouverture optique du dispositif de la figure 1 remplit les fonctions suivantes :
- définir avec la meilleure précision possible un seul et unique axe optique passant par le centre du diaphragme d'entrée du système d'optique électro-statique et le centre des diverses électrodes (non représentées) définissant les deux lentilles électro-statiques, et
- permettre un changement très rapide du paramètre d'ouverture optique de la colonne à ions focalisés.

Il convient de noter que le fait de disposer de plusieurs diaphragmes permet de disposer d'une possibilité de réglage plus importante du système d'optique électro-statique et en outre d'espacer les interventions destinées à l'entretien du dispositif.

On considère maintenant des procédés conformes à l'invention, en particulier des procédés de focalisation et d'ajustement de la taille d'un champ d'écriture en nano-fabrication par faisceau d'ions focalisé. Ces procédés sont importants en vue d'une automatisation performante de la nano-fabrication par FIB.

Les procédés que l'on explique ci-après visent à résoudre le problème fondamental du réglage des paramètres d'une colonne ionique fournissant une sonde ionique (faisceau d'ions focalisé que l'on envoie sur une cible) à l'échelle d'une dizaine de nanomètres.

Cette sonde ionique est destinée à former des structures de taille nanométrique par irradiation ionique contrôlée.

La forme géométrique (taille), l'allure (décroissance plus ou moins rapide du nombre de particules lorsque l'on s'éloigne de l'axe central du faisceau) ainsi que le caractère sphérique de la distribution dans la sonde ionique au niveau de la cible sont prépondérants. A une échelle de quelques nanomètres, les problèmes sont d'autant plus compliqués.

Les procédés proposés ici visent à permettre un ajustement rapide et très précis du profil de cette sonde ionique en mode manuel (nécessitant l'intervention des utilisateurs), automatique (ne nécessitant aucune intervention) ou semi-automatique.

Les points concernés sont :
- la focalisation (concentration) du faisceau d'ions sous l'action des lentilles électro-statiques (que comporte le dispositif de génération du faisceau), au niveau d'une cible ou d'un échantillon, dans une tache (impact) de dimensions nanométriques,
- la correction des défauts de sphéricité de la sonde ionique incidente, et
- l'étalonnage du champ d'écriture (champ adressable par le faisceau sous l'action de déflecteurs électro-statiques) à la surface de la cible, de façon à toujours en connaître précisément la position relative à quelques nanomètres près.

On précise que le dispositif de génération du faisceau comprend des déflecteurs électrostatiques, destinés à dévier ce faisceau, et que le système particulier d'optique électro-statique 14 de la figure 1 contient des électrodes de balayage non représentées qui forment les déflecteurs électro-statiques.

Considérons les problèmes à résoudre.

L'utilisation d'un faisceau d'ions focalisé dans une tache de 10 nm pour des applications de nano-fabrication a des contraintes spécifiques qui sont très différentes de celles qui interviennent par exemple en microscopie électronique à balayage :
- L'effet de pulvérisation induit par les ions énergétiques qui bombardent la cible conduit à détruire à plus ou moins long terme les structures d'étalonnage (généralement des marqueurs d'or sur du silicium) qui sont classiquement utilisées par exemple en lithographie par faisceau d'électrons. De plus, des structures calibrées de quelques dizaines de nanomètres sont délicates à fabriquer, très fragiles et surtout coûteuses.
- La durée d'utilisation du faisceau d'ions peut atteindre plusieurs heures, ce qui impose de contrôler périodiquement les caractéristiques de ce faisceau d'ions pour limiter l'influence des dérives et des instabilités transitoires.
- Les distances de travail réduites, qui sont nécessaires à l'obtention d'un grossissement géométrique de la tache de source inférieur à 1, réduisent d'autant la profondeur de champ utilisable. De plus, certains échantillons comportent des motifs de hauteurs très différentes les unes des autres, de sorte que ces motifs ne sont pas tous situés à la distance focale idéale.
- Dans ce dernier cas, un ion qui tombe sur un tel échantillon au niveau de l'axe optique parcourt un chemin beaucoup plus court qu'un autre ion ayant été dévié de plusieurs millimètres par rapport à cet axe. Cette différence de chemin optique provoque l'apparition de défauts ou aberrations. Pour limiter ces aberrations à une valeur acceptable, on limite la taille d'écriture dans un champ de l'ordre d'une centaine de micromètres. Ainsi, sans dispositif annexe, la technique de nano-fabrication par FIB ne peut former que de petits motifs élémentaires.
- Lorsqu'un déplacement ultra-précis de l'échantillon est utilisé, la possibilité de raccorder plusieurs sous-structures élémentaires pour définir un motif de plus grande taille apparaît. Mais cela reste subordonné à une calibration rigoureuse de la taille du champ d'écriture élémentaire par FIB. En effet, une correspondance la plus parfaite possible entre les coordonnées des points définis à l'intérieur d'un champ de balayage et les coordonnées de déplacement de la platine qui porte l'échantillon est nécessaire.
   Tout cela est complexe car le balayage de la sonde ionique est obtenu à l'aide d'un générateur de CAO (conception assistée par ordinateur) du genre numérique/analogique alors que la platine portant l'échantillon est, quant à elle, pilotée par une interface spécifique et indépendante. Il convient également de noter que toute variation de la distance entre l'échantillon et la colonne ionique, de l'énergie des ions ou de la nature de ces derniers modifie la valeur de l'amplitude du champ de balayage.
   Dans la présente invention, on propose un procédé rapide, très précis et susceptible d'être automatisé pour calibrer le système optique d'une colonne ionique, en utilisant la propriété qu'ont des ions incidents lourds, tels que des ions de gallium ou d'autres métaux par exemple l'aluminium, de graver localement la cible qu'ils frappent.
   Avec ce procédé, le même dispositif de génération de faisceau d'ions est capable de former ses propres marques de calibration puis de les vérifier en complète autonomie.
- On propose tout d'abord d'utiliser l'effet d'érosion du faisceau d'ions incident, engendré par un dispositif de génération de faisceau d'ions, pour graver une structure simple, selon un motif prédéterminé par CAO, par exemple du type carré, trou simple ("spot") ou croix, dans une zone "sacrifiée" de l'échantillon. Après gravure par FIB, cette structure est ensuite imagée par le même dispositif que l'on fait alors fonctionner en mode de MIB ou Microscopie Ionique à Balayage, dans les mêmes conditions, sans aucune modification, en collectant simplement les électrons secondaires qui résultent du balayage de la surface de l'échantillon par le faisceau d'ions. L'image de MIB obtenue est numérisée et, sur cette image de MIB numérisée, correspondant à la structure effectivement gravée, il est alors possible de superposer informatiquement le motif prédéterminé initial numérisé (carré, trou ou croix par exemple) et de différencier (de manière numérique) les deux images. Dans le cas d'un motif de type carré par exemple, on peut alors détecter un défaut provenant d'une mauvaise focalisation puis y remédier en augmentant pas à pas l'effet focalisateur des lentilles dont est pourvu le dispositif de génération de faisceau. Le processus peut être automatisé pour différents grossissements et être répété étape par étape, jusqu'à ce que l'image de MIB numérisée et le motif initial coïncident parfaitement.
- Le même effet d'érosion peut aussi être mis à profit pour corriger un défaut éventuel de "sphéricité", encore appelé défaut d'astigmatisme, au niveau de la tache des ions incidents. Dans ce cas, le perçage d'un unique trou de l'ordre de 10 à 20 nm permet d'obtenir très rapidement, en quelques dixièmes de seconde, une image fidèle de l'empreinte de la sonde ionique. Si une allure elliptique de la tache est mise en évidence, toujours par comparaison avec une image "idéale" de référence (image circulaire), et selon l'orientation de l'ellipse obtenue, il est possible de déclencher une procédure de corrections et tests itératifs, jusqu'à ce que le critère de décision satisfaisant, établi par les utilisateurs, fasse sortir le système informatique utilisé de cette séquence (de préférence automatique).
- L'étalonnage de la taille du champ d'écriture par FIB est le dernier point crucial qu'il est possible de mettre en oeuvre, de préférence de manière automatisée, avec un procédé conforme à l'invention. Ce procédé consiste d'abord à graver des traits (réseau de traits parallèles ou réseau de traits croisés) ayant une longueur connue avec une très faible incertitude. Pour ce faire, le faisceau d'ions est maintenu en mode "spot" et ne balaye pas la surface de l'échantillon tandis que ce dernier est déplacé par l'intermédiaire de la platine qui supporte cet échantillon, la mesure des déplacements de cette platine étant effectuée par interférométrie laser. Dans ce cas, la précision mécanique peut descendre jusqu'à quelques nanomètres (de l'ordre de 10 nm à 5 nm).

Dans ce cas, les marqueurs sont formés non pas en balayant la surface de la cible par la sonde ionique mais uniquement en déplaçant cette cible, l'axe central du faisceau d'ions de gravure étant maintenu fixe. Une image de MIB des structures ainsi fabriquées permet alors, après numérisation de cette image, d'ajuster le gain de l'étage amplificateur du dispositif de génération du faisceau de façon qu'un poids numérique de 1 ou quelques bits corresponde à un déplacement connu (d'un certain nombre de nanomètres) au niveau de l'échantillon. L'étalonnage du champ de balayage est alors réalisé avec la technique de mesure par interférométrie laser, technique la plus performante connue à ce jour pour mesurer des déplacements relatifs, technique qui est d'ailleurs utilisée par le Bureau National des Mesures.

## Revendications

1. Procédé de réglage d'un faisceau d'ions qui est émis par un dispositif de génération de faisceau d'ions vers une cible et qui est apte à éroder cette cible, ce procédé étant **caractérisé en ce qu'**il comprend une étape de gravure d'un motif de test sur la cible, selon un motif de référence prédéterminé numérisé, une étape de formation d'une image numérisée du motif de test gravé et une étape de différenciation entre cette image numérisée du motif de test gravé et l'image numérisée du motif de référence prédéterminé, et **en ce qu'**on répète ces étapes après modification d'au moins un paramètre de réglage du dispositif, jusqu'à l'obtention d'un réglage convenable.

2. Procédé selon la revendication 1, dans lequel on forme l'image du motif de test, au moyen du dispositif, en faisant alors fonctionner ce dernier en mode de microscope ionique à balayage et en collectant les électrons secondaires engendrés en balayant la cible par le faisceau d'ions, et l'on numérise l'image obtenue, et en ce que les étapes sont répétées après modification d'au moins un paramètre de réglage du dispositif, jusqu'à ce que l'image numérisée du motif de test coïncide avec l'image numérisée du motif de référence.

3. Procédé selon la revendication 2, dans lequel le ou les paramètres de réglage sont des paramètres de focalisation.

4. Procédé selon la revendication 2, dans lequel le ou les paramètres de réglage sont des paramètres de correction d'astigmatisme.

5. Procédé selon la revendication 1, dans lequel le motif de test est un ensemble de traits de longueur prédéterminée, formé en maintenant le faisceau d'ions dans une position fixe et en déplaçant la cible, et l'image du motif de test est formée par microscopie ionique à balayage puis numérisée et les paramètres sont des paramètres de gain, en vue de l'étalonnage de la taille du champ d'écriture.

## Claims

1. A method for calibrating a ion beam emitted by a ion beam generation device toward a target and suitable for eroding said target, the method being **characterized in that** it comprises a step of etching a test pattern on the target according to a predetermined digitized reference pattern, a step of forming a digitized image of the etched test pattern and a step of differentiating between said digitized image of the etched test pattern and the digitized image of the predetermined reference pattern, and **in that** said steps are repeated after modification of at least a calibration parameter of the device until a suitable calibration is obtained.

2. A method according to claim 1, wherein the etched test pattern is imaged by operating the device in a scanning ion microscope mode and collecting secondary electrons produced by scanning the target with the ion beam, wherein the obtained image is digitized and wherein the steps are repeated after modification of at least a calibration parameter of the device until the digitized image of the test pattern coincides with the digitized image of the reference pattern.

3. A method according to claim 2, wherein the calibration parameters are focusing parameters.

4. A method according to claim 2, wherein the calibration parameter(s) are astigmatism correction parameters.

5. A method according to claim 1, wherein the test pattern is a set of lines having a predetermined length, formed by keeping the ion beam in a fixed position and by moving the target, and wherein the test pattern image is formed by scanning ion microscopy, then digitized, and the parameters are gain parameter for calibrating the size of the writing field.

## Patentansprüche

1. Verfahren zur Regelung eines Ionenstrahls, der von einer Vorrichtung zur Erzeugung von Ionenstrahlen auf ein Ziel emittiert wird, und der geeignet ist, dieses Ziel zu erodieren, wobei dieses Verfahren **dadurch gekennzeichnet ist, dass** es einen Schritt des Ätzens eines Testmusters auf das Ziel gemäß einem vorbestimmten nummerierten Bezugsmuster, einen Schritt der Erzeugung eines numerisierten Bildes des geätzten Testmusters sowie einen Schritt der Differenzierung zwischen diesem numerisierten Bild des geätzten Testmusters und dem numerisierten Bild des vorbestimmten Bezugsmusters umfasst, und dass diese Schritte nach Modifikation mindestens eines Regelungsparameters der Vorrichtung bis zum Erhalt einer geeigneten Regelung wiederholt werden.

2. Verfahren nach Anspruch 1, wobei das Bild des Testmusters mittels der Vorrichtung erzeugt wird, indem hierbei letztere im Abtast-Ionenmikroskopmodus betrieben wird, und die bei der Abtastung des Ziels durch den Ionenstrahl erzeugten Sekundärelektronen gesammelt werden und das erhaltene Bild nummeriert wird, und wobei die Schritte nach Modifikation mindestens eines Regelungsparameters der Vorrichtung wiederholt werden, bis das nummerierte Bild des Testmusters mit dem nummerierten Bild des Bezugsmusters koinzidiert.

3. Verfahren nach Anspruch 2, wobei der oder die Regelungsparameter Fokussierungsparameter sind.

4. Verfahren nach Anspruch 2, wobei der oder die Regelungsparameter Astigmatismus-Korrekturparameter sind.

5. Verfahren nach Anspruch 1, wobei das Testmuster eine Einheit von Strichen vorbestimmter Länge ist, die erzeugt werden, indem der Ionenstrahl in einer feststehenden Position gehalten wird und das Ziel bewegt wird, und das Bild des Testmusters durch Abtast-Ionenmikroskopie erzeugt und dann nummeriert wird, und die Parameter Verstärkungsparameter hinsichtlich der Markierung der Größe des Schreibfeldes sind.
